Europäisches Patentamt

European Patent Office

Office européen des brevets

(11) Publication number: **0 093 971**

**B1**

(12) **EUROPEAN PATENT SPECIFICATION**

(45) Date of publication of patent specification: **16.08.90**

(51) Int. Cl.⁵: **H 01 L 21/285,** H 01 L 29/40, H 01 L 23/48

(21) Application number: **83104176.9**

(22) Date of filing: **28.04.83**

(54) **Semiconductor device having an interstitial transition element layer and method of manufacturing the same.**

(30) Priority: **28.04.82 JP 70402/82**

(43) Date of publication of application: **16.11.83 Bulletin 83/46**

(45) Publication of the grant of the patent: **16.08.90 Bulletin 90/33**

(84) Designated Contracting States: **DE FR GB NL**

(56) References cited:
**WO-A-82/03948**    **GB-A-1 469 953**
**AU-B- 479 562**    **GB-A-2 083 949**
**DE-A-1 955 716**    **GB-A-2 104 290**
**FR-A-2 358 751**    **US-A-3 907 620**

**IBM TECHNICAL DISCLOSURE BULLETIN, vol. 24, no. 4, September 1981, pages 1976-1977, New York, USA; C.Y. TING: "Using titanium nitride and silicone for VLSI contacts"**

**The file contains technical information submitted after the application was filed and not included in this specification**

(73) Proprietor: **KABUSHIKI KAISHA TOSHIBA 72, Horikawa-cho Saiwai-ku Kawasaki-shi Kanagawa-ken 210 (JP)**

(72) Inventor: **Yawata, Shigeo 1088-2, Kitakase Saiwai-ku Kawasaki-shi (JP)**
Inventor: **Hiraki, Shun-ichi 9-1-303, Takara-cho Hiratsuka-shi Kanagawa-ken (JP)**
Inventor: **Yokata, Yoshio 202 Yoshida-Bldg. 4-27-17 Higashiogu Arakawa-ku Tokyo (JP)**

(74) Representative: **Lehn, Werner, Dipl.-Ing. et al Hoffmann, Eitle & Partner Patentanwälte Arabellastrasse 4 D-8000 München 81 (DE)**

**Description**

The present invention relates to a semiconductor device and a method for manufacturing the same, wherein a layer of an interstitial transition metal compound is directly deposited on a semiconductor substrate to obtain a good ohmic contact.

Conventionally, to form an electrode in ohmic contact with a semiconductor substrate, aluminum, for example, is heated at a temperature of 500°C or lower to produce a eutectic layer with the semiconductor substrate. Alternatively, molybdenum (Mo), tungsten (W), titanium (Ti), or the like, is used in place of aluminum, so as to form an electrode which does not melt at a temperature of about 500°C. When such a high melting-point metal is used, an underlying metal layer is formed in ohmic contact with the semiconductor substrate and an electrode of the high melting-point metal is formed on the underlying layer, thereby obtaining the ohmic contact. The formation of the high melting-point metal layer serves to provide a barrier effect, so as to prevent diffusion of an impurity predoped in the semiconductor substrate to the overlying electrode on this high melting point metal layer through the underlying layer and the high melting-point metal layer itself and to prevent diffusion of an electrode metal from the electrode through this high melting-point metal layer and the underlying layer to the semiconductor substrate. For this reason, when a high melting-point metal is used, the electrode has a multilayer structure. As a result, the number of manufacturing steps is increased. Furthermore, annealing at a temperature of 500°C or higher must be completed before the electrode is deposited, thereby limiting the manufacturing procedures.

Titanium nitride (TiN) which has good heat resistance has received a great deal of attention as an electrode material. The use of TiN for semiconductor contacts has been reported in the IBM Technical Disclosure Bulletin, volume 24, No, 4, September 1981, page 1976. It has also been reported in the Report of the Technical Study of Electronics and Communications Association (SDD 81—47 to 50, Vol 81, No. 125, September 22, 1981) that a high melting-point metal layer of titanium nitride, when used as an electrode material, has an excellent barrier effect and a low electrical resistance at its high melting point (about 2,900°C). However, according to this report, the TiN film was not directly deposited on a polycrystalline silicon substrate, but through a Ti metal layer. Therefore, even when a TiN film is used as the electrode, it cannot be expected from the above report that ohmic contact may be obtained between the electrode and the semiconductor substrate. Even if a high melting-point metal layer of TiN or the like is used as the electrode, a multilayer electrode structure has been conventionally utilized, as a diffusion barrier. As a result, the manufacturing process is inevitably complicated.

Furthermore, a buffer mask made of thermal oxide, polycrystalline silicon, CVD silicon oxide or silicon nitride cannot be used when a semiconductor of a Group III—V compound such as gallium arsenide is used as a material of a semiconductor substrate at the time of ion-implantation. This is because these films react with the semiconductor substrate when they are formed or when annealing is performed at a high temperature, so that either these films cannot be eliminated or an active portion is left on the surface of the semiconductor substrate even after these films are eliminated. Therefore, a buffer mask cannot be used and a semiconductor substrate of a Group III—V compound which is damaged at the time of ion-implantation cannot be completely recovered. In the case of selectively forming a silicon oxide film by the CVD method as a mask for ion-implantation, the following problem occurs besides the drawback which occurs at the time of its removal. Oxygen (O) of the silicon oxide film has an affinity with arsenic (As) of the Group III—V compound semiconductor substrate. Furthermore, a great amount of impurity is contained in the silicon oxide film. Therefore, a "surface state" occurs at an interface between the silicon oxide film and the substrate which degrades element characteristics, during annealing (750°C to 850°C) for activatiang ion-implanted impurity ions. Furthermore, when a CVD silicon oxide film is used as a buffer mask, it does not provide a diffusion barrier effect against arsenic. As a result, proper control of the impurity concentration is difficult to attain.

A technique has long been in demand for forming a buffer mask with a diffusion barrier effect on a semiconductor substrate of a Group III—V compound.

One object of the present invention is to provide a semiconductor device whose electrode comprises a high melting-point metal with a low electrical resistance, provides a diffusion barrier effect and is directly formed in ohmic contact with a semiconductor substrate.

Another object of the present invention is to provide a method for manufacturing a semiconductor device whose electrode comprises a high melting-point metal with a low electrical resistance, provides a diffusion barrier effect and is directly formed in ohmic contact with a semiconductor substrate.

Still another object of the present invention is to provide a method for manufacturing a semiconductor device wherein a buffer mask can be formed for ion-implantion of a impurity into a semiconductor substrate of a Group III—V compound.

A further object of the present invention is to provide a method for manufacturing a semiconductor device wherein ion-implantation of an impurity into a semiconductor substrate of a Group III—IV compound can be performed by using a buffer mask.

To achieve the above objects of the present invention, an interstitial transition metal compound is deposited as a buffer mask on a semiconductor substrate. An impurity is ion-implanted in the buffer mask and the semiconductor substrate. Part of the energy of ion-implantation is absorbed by the buffer mask, thereby decreasing the damage to the semiconductor substrate. The damage to the semiconductor substrate which is caused by impurity ions transmitted through the buffer mask can be repaired by annealing at a high temperature to activate the impurity. Furthermore, a non-stoichiometrical region can be stoichiometrically stabilized by the impurity ions by this annealing at a high temperature. As a result, the interstitial transition element layer can achieve ohmic contact with the semiconductor substrate. By utilizing this effect, the interstitial transition element layer is selectively left as an electrode, thereby achieving the above objects of the present invention.

This invention can be more fully understood from the following detailed description when taken in conjunction with the accompanying drawings, in which:

Fig. 1 is a sectional view showing a basic elemental structure of a field effect transistor, to explain a semiconductor device according to an embodiment of the present invention; and

Figs. 2 to 7 are sectional views explaining the main steps in manufacturing the semiconductor device shown in Fig. 1, according to a method for manufacturing the semiconductor device of the present invention.

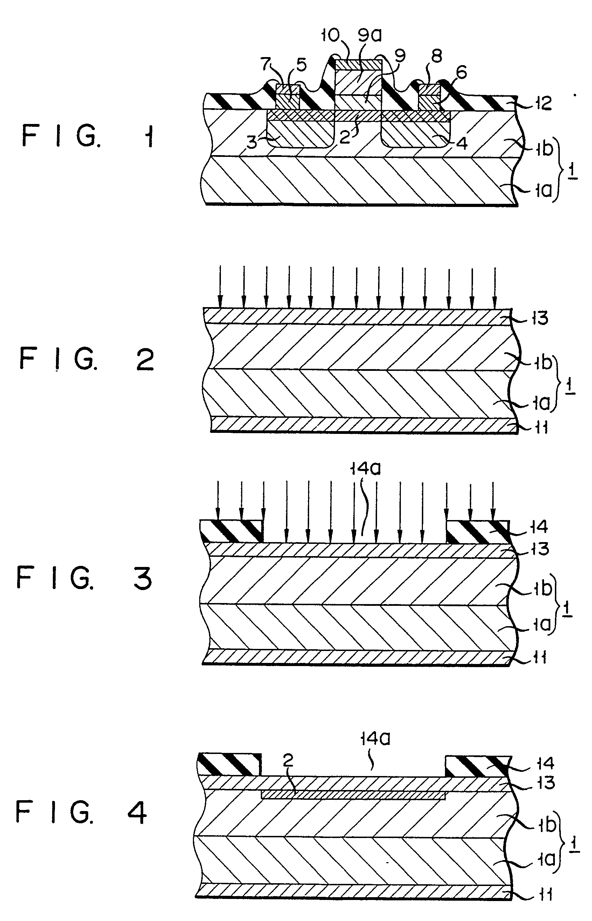

Fig. 1 is a sectional view showing a field effect transistor according to an embodiment of the present invention. In this field effect transistor, silicon ions are doped in a Cr-doped GaAs semiconductor substrate 1, from one major surface thereof, so as to form a channel region 2, and source and drain regions 3 and 4. TiN compound electrode layers 5 and 6 are in direct ohmic contact with source and drain regions 3 and 4, respectively. Wiring layers 7 and 8 are deposited on TiN compound electrode layers 5 and 6, respectively. TiN compound gate electrode layers 9 and 9a are successively deposited on the channel region 2, so as to form a Schottky junction therebetween. A wiring layer 10 is deposited on TiN compound gate electrode layer 9a. An exposed portion of the one major surface of the GaAs semiconductor substrate 1 is covered with a silicon compound protective film 12, such as a silicon oxide film. The electrode layers 5, 6 and 9 contain arsenic, and the electrodes 5, 6, 9 and 9a contain silicon. The concentration of the impurity in the channel region 2 is controlled to form the Schottky junction between the TiN compound gate electrode layer 9 and the channel region 2. The TiN compound electrode layers 5, 6 and the gate electrode layers 9, 9a contain a 10 to 80 atomic % of nitrogen.

The field effect transistor having the above structure is manufactured in the following manner.

A GaAs wafer 1a is doped with Cr so as to prepare a semi-insulating GaAs wafer. A GaAs semiconductor substrate 1 is formed by growing a GaAs epitaxial layer 1b of 6 to 7 µm thickness by epitaxial growth on the Cr-doped GaAs wafer 1a, as shown in Fig. 2. Thereafter, TiN compound layers 11 and 13 of an interstitial transition metal compound are formed by reactive RF sputtering on the two major surfaces of the GaAs semiconductor substrate 1. Each of TiN compound layers 11 and 13 has a thickness of about 1,000 Å (100nm). The deposition of the TiN compound layers is interrupted to dope As ions and then to form a high-impurity region in the TiN compound layer 13 when the thickness of the TiN compound layer 13 reaches 300 Å (30 nm). After the As ions are doped in the TiN compound layer 13, the TiN compound layer 13 is preferably deposited to a further thickness of 700 Å (70 nm). In this case, the As ions are ion-implanted at a dosage level of $10^{16}$ cm$^{-2}$ and at an acceleration voltage of 60 KeV, thereby decreasing the damage to the GaAs semiconductor substrate 1.

TiN compound layers 11 and 13 respectively contain a 10 to 80 atomic % of nitrogen. When titanium carbide (TiC) is used instead of TiN as an interstitial transition metal compound layer, carbon must be contained within a range between 10 to 80 atomic %.

Fig. 2 is a sectional view explaining the manufacturing step described above. Referring to Fig. 2, the TiN compound layer 13 is formed on the GaAs epitaxial layer 1b of the GaAs semiconductor substrate 1 and the As ions are ion-implanted in the TiN compound layer 13 in the direction indicated by the arrows.

Then, a small amount of germanium (Ge) is introduced into the TiN compound layer 11. The germanium content and the concentration of the impurity in the surface layer of the GaAs semiconductor substrate 1 are controlled to provide the ohmic contact or the Schottky junction between the TiN compound layer 11 and the GaAs semiconductor substrate 1.

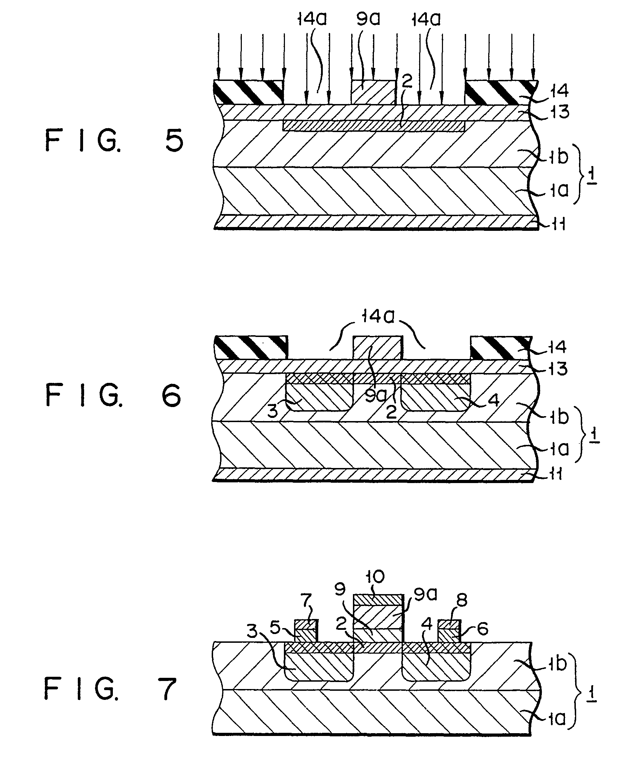

As shown in Fig. 3, a silicon compound layer is formed on the TiN compound layer 13 to a thickness of about 4,300 Å (430 nm) at a temperature in the range between room temperature and 710°C. Thereafter, the silicon compound layer is selectively photoengraved to obtain a mask 14 for ion-implantation. Si ions are ion-implanted in a direction indicated by arrows in a portion of the TiN compound layer 13 which corresponds to a contact hole 14a (Fig. 3). As a result, Si regions are respectively formed in parts of the TiN compound layer 13 and the GaAs semiconductor substrate 1 and, hence, a channel region 2 is formed in a surface layer of the GaAs semiconductor substrate 1, as shown in Fig. 4. It is to be noted that the channel region 2 is annealed at a high temperature in the subsequent process, so as to activate the Si ions in the channel region 2, and that the Schottky junction is formed between the TiN compound gate electrode layer 9 and the channel region 2.

The TiN compound gate electrode layer 9a is deposited on a prospective gate formation region to a thicknes of about 2,000 Å (200 nm). The thickness of the TiN compound gate electrode layer 9a is determined in accordance with the conditions for ion-implanting the impurity in the prospective source and drain regions.

Thereafter, si ions are again ion-implanted in the manner shown in Fig. 5. More specifically, the TiN compound gate electrode layer 9a blocks the Si ions, which diffuse into only the portions of the GaAs epitaxial layer 1b other than those which lie immediately below the TiN compound gate electrode layer 9a. As shown in Fig. 6, source and drain regions 3 and 4 are selectively formed in the GaAs epitaxial layer 1b. The wafer is then annealed in an Ar atmosphere at a temperature of 800°C for 30 minutes. By this annealing, impurity ions such as the As and Si ions in the TiN compound layer 13, the channel region 2, the source region 3 and the drain region 4 are activated. At the same time, the damage is recovered and the interface between the GaAs semiconductor substrate 1 and the TiN compound layer 13 is stoichiometrically stabilized.

More specifically, ohmic contact is provided at interfaces between sourch and drain regions 3 and 4 and corresponding portions of the TiN compound layer 13. Furthermore, the Schottky junction is formed at the interface between the channel region 2 and the TiN compound layer 13.

Thereafter, a metal such as gold (Au) is deposited on TiN compound gate electrode layers 9a and 13. The gold deposition layer is selectively etched, as shown in Fig. 7, thus obtaining TiN compound electrode layers 5 and 6, TiN compound gate electrode layers 9 and 9a, and wiring layers 7, 8 and 10. When the mask 14 and the TiN compound layer 11 are removed, the semiconductor structure shown in Fig. 7 is prepared.

In the final manufacturing step, a silicon compound protective layer 12 of silicon oxide is deposited by CVD to cover the entire surface of the GaAs semiconductor substrate 1. The wafer is then annealed in an Ar atmosphere at a temperature of 450°C for 20 minutes, thereby preparing the basic element structure shown in Fig. 1.

In the above embodiment, the field effect transistor is manufactured by using a GaAs semiconductor substrate. However, the present invention can also be applied to cases wherein a silicon substrate, a semiconductor substrate of a Group III—V compound (e.g., GaP, $GaAl_xAs_{1-x}$, $GaAs_yP_{1-y}$ or the like), or a semiconductor substrate of four Group III—V compounds, i.e., of four elements selected from among Ga, P, In, Sb, As and Al is used.

According to claim 11 the impurity of the diffusion region is one element selected from the group consisting of P, B, Ge, Si, As, Al, Te and Sn. The impurity of the interstitial transition metal compound layer (5, 6) and the ohmic contact impurity region is one element selected from the group consisting of As, Ga, Zn, Al, S, Si, Ge, In, P, Sb, Te and Sn. The impurities of said diffusion region, said interstitial transition metal compound layer (5, 6) and said ohmic contact impurity region have a concentration of $10^{17}$ to $10^{21}$ cm$^{-3}$.

The field effect transistor of the present invention, which is manufactured by the above method, has the following advantages as compared with a conventional FET in which an interstital transition element layer is used. The gain of the FET of the present invention is 20 to 25 dB at a frequency bandwidth of 800 MHz, while that of the conventional FET is 16 to 20 dB. The noise level of the FET of the present invention is 0.8 to 1.2 dB, whereas that of the conventional FET is 1.3 to 2.6 dB, at the frequency bandwidth of 800 MHz.

According to the method of the present invention, when a shallow junction in the orders of atoms up to several hundreds of nanometres is formed by using a silicon substrate, annealing at a high temperature of 900°C to 1,000°C can be performed for the following reason. When a desired thin film such as a silicon oxide film is formed on an interstitial transition metal compound layer at a temperature in a range between room temperature and 710°C, reaction of the interstitial transition metal compound layer with a gas in either an inert or oxygen gas atmosphere is prevented. Furthermore, when the semiconductor substrate comprisss a semiconductor of Group III—V compound and when the thin film is formed on the interstitial transition metal compound layer at a lower temperature within the range between room temperature and 400°C, the interstitial transition metal compound layer still remains at the end of low-temperature annealing. As a result, the diffusion of As from the semiconductor substrate is prevented, thereby preventing the occurrence of the "surface state" caused by arsenic activation at the time of formation of the thin film.

As a result, the interstitial transition metal compound layer can be used as a buffer mask at the time of ion-implantation. Furthermore, an ohmic contact is provided, due to the presence of the interstitial transition metal compound layer.

Briefly summarized, the invention provides a method in which an interstitial transition metal compound layer (13) is formed on a semiconductor substrate (1). An impurity is ion-implanted in the semiconductor substrate (1) using the interstitial transition metal compound layer (13) as a mask. A damaged non-stoichimetry region is formed. This region is recovered by annealing at a high temperature. At the same time, the impurity is activated to stoichiometrically stabilize an interface between the semiconductor substrate (1) and the interstitial transition metal compound layer (13), thereby allowing for a semiconductor device which has an electrode in ohmic contact with the semiconductor substrate (1).

**Claims**

1. A method for forming a semiconductor device, comprising the steps of:
—depositing a first interstitial transition metal compound layer (13) on a major surface of a semiconductor substrate of a first conductivity type;
— forming a mask (14) on said interstitial transition metal compound layer (13);

—using the mask (14) to selectively dope an impurity of a second conductivity type in said semiconductor substrate through said interstitial metal compound layer (13) to form a channel region (2), selectively depositing a second interstitial transistion metal compound layer (9a) on said first interstitial transition metal compound layer (13) said second interstitial transition metal compound layer forming a gate electrode (9a), doping a further impurity of the second conductivity type for forming source and drain regions (3, 4) in said semiconductor substrate (1) using said gate electrode (9a) as a mask, patterning said first interstitial transition metal compound layer (13) to form source and drain electrodes and annealing the thus formed structure, the impurities and annealing temperature being such that ohmic contact between the source and drain electrodes and said semicondouctor substrate is obtained, and a Schottky junction is obtained between said gate electrode (9a) and said semiconductor substrate.

2. A method according to claim 1, characterized in that an interstitial transition metal compound used for forming said interstitial transition metal compound layer (13) is at least one element selected from the group consisting of Ti, Hf, Zr, Ta, Nb and Sc.

3. A method according to claim 1 or 2, characterized in that said interstitial transition metal compound layer (13) contains an element selected from the group consisting of nitrogen and carbon.

4. A method according to claim 3, characterized in that the content of nitrogen or carbon contained in said interstitial transition metal compound layer (13) falls within a range between 10 atomic % and 80 atomic %.

5. A method according to claim 1 or 2, characterized in that the impurity for forming the ohmic contact which is doped in said semiconductor substrate (1) and said interstitial transition metal compound layer (13) is one element selected from the group consisting of As, Ge, P and Al and has a concentration of $10^{17}$ to $10^{21}$ cm$^{-3}$.

6. A method for forming a semiconductor substrate according to claim 1, characterized in that said step of depositing said first interstitial transition metal compound layer (13) is interrupted so as to dope As ions in said first layer (13) and thereby to form an impurity region in said first layer (13).

7. A. semiconductor device obtainable by the process according to claim 1 comprising:

a semiconductor substrate (1) of one conductivity type;

a diffusion region (2) extending from a major surface of said semiconductor substrate (1) to an inside thereof, said diffusion region having an impurity of the conductivity type opposite to that of the semiconductor substrate and forming a channel region;

further diffusion regions (3, 4) having said impurity of opposite conductivity type extending from said major surface forming source and drain regions self-aligned to a gate region;

a patterned layer comprising a transition metal compound on said semiconductor substrate forming source (5), gate (9) and drain (6) contacts;

said transition metal compound being an interstitial transition metal compound rendered stoichiometric because of its content of said impurity of opposite conductivity type;

an ohmic contact being formed between the source (5) and drain (6) contacts and the substrate (1);

a Schottky junction being formed between the gate contact (9) and the substrate.

8. A device according to claim 7, characterized in that the transition metal for forming said interstitial transistion metal compound layer (5, 6) includes at least one element selected from the group consisting of Ti, Hf, Zr, Ta, Nb and Sc.

9. A device according to claim 7 or 8, characterized in that said interstitial transition metal compound layer (5, 6) contains an element selected from the group consisting of nitrogen and carbon.

10. A device according to claim 9, characterized in that a content of nitrogen or carbon contained in said interstitial transition metal compound layer (5, 6) falls within a range between 10 atomic % and 80 atomic %.

11. A device according to claim 7 or 9, characterized in that the impurity of said diffusion region is one element selected from the group consisting of P, B, Ge, Si, As, Al, Te and Sn; the impurity of said interstitial transition metal compound layer (5, 6) and said ohmic contact impurity region is one element selected from the group consisting of As, Ga, Zn, Al, S, Si, Ge, In, P, Sb, Te and Sn; and the impurities of said diffusion region, said interstitial transition metal compound layer (5, 6) and said ohmic contact impurity region have a concentration of $10^{17}$ to $10^{21}$ cm$^{-3}$.

**Patentansprüche**

1. Verfahren zum Bilden einer Halbleiteranordnung, enthaltend die Schritte:

—Abscheiden einer ersten Schicht (13) einer nichtstöchiometrischen Übergangsmetallverbindung auf eine Hauptoberfläche eines Halbleitersubstrats eines ersten Leitfähigkeitstyps;

—Bilden einer Maske (14) auf der Schicht (13) einer nicht-stöchiometrischen Übergangsmetallverbindung;

—Verwenden der Maske (14) zum selektiven Dotieren eines Störstoffs eines zweiten Leitfähigkeittyps in das Halbleitersubstrat durch die Schicht (13) einer nicht stöchiometrischen Metallverbindung, um einen Kanalbereich (2) zu bilden, selektives Abscheiden einer zweiten Schicht (9a) einer nichtstöchiometrischen Übergangsmetallverbindung auf der ersten Schicht einer nichtstöchiometrischen Übergangsmetallverbindung (13), wobei die zweite Schicht einer nicht stöchiometrischen Übergangsmetallverbindung eine Gate-Elektrode (9a) bildet, Dotieren eines weiteren Störstoffs des zweiten Leitfähigkeittyps zum Bilden von Quellen und Senkenbereichen (3, 4) in dem Halbleitersubstrat (1) mittels der Gate-Elektrode (9a) als Maske, Versehen der ersten Schicht (13) einer nicht-stöchiometrischen Übergangsmetallverbindung mit einem Muster, un Quellen-und Senkenelektroden zu bilden, und Ausglühen der dadurch gebildeten Struktur, wobei die Störstoffe und Glühtemperatur derart sind, daß der ohm-'sche Kontakt zwischen den Quellen- und Senkenelektroden und dem Halbleitersubstrat und eine Schottky-Verbindung zwischen der Gate-Elektrode (9a) und dem Halbleitersubstrat erhalten wird.

2. Verfahren nach Anspruch 1, dadurch gekennzeichnet, daß eine nicht stöchiometrische Übergangsmetallverbindung, die zum Bilden der Schicht (13) einer nicht-stöchiometrischen Übergangsmetallverbindung verwendet wird, mindestens ein Element ausgewählt aus der Gruppe bestehend aus Ti, Hf, Zr, Ta, Nb und Sc, ist.

3. Verfahren nach Anspruch 1 oder 2, dadurch gekennzeichnet, daß die Schicht (13) einer nicht-stöchiometrischen Übergangsmetallverbindung ein Element, ausgewählt aus der Gruppe bestehend aus Stickstoff und Kohlenstoff enthält.

4. Verfahren nach Anspruch 3, dadurch gekennzeichnet, daß der Bestandteil von Stickstoff oder Kohlenstoff, der in der Schicht (13) einer nicht-stöchiometrischen Übergangsmetallverbindung enthalten ist, innerhalb eines Bereichs zwischen 10 atomische % und 80 atomische % liegt.

5. Verfahren nach Anspruch 1 oder 2, dadurch gekennzeichnet, daß der Störstoff zum Bilden des ohm'schen Kontakts, der in das Halbleitersubstrat (1) und die Schicht (13) einer nicht-stöchiometrischen Übergangsmetallverbindung dotiert ist, ein Element ausgewählt aus der Gruppe bestehend aus As, Ge, P und A ist und eine Konzentration von $10^{17}$ bis $10^{21}$ $cm^{-3}$ aufweist.

6. Verfahren zum Bilden eines Halbleitersubstrats nach Anspruch 1, dadurch gekennzeichnet, daß der Schritt des Abscheidens der ersten Schicht (13) einer nicht-stöchiometrischen Übergangsmetallverbindung unterbrochen wird, um As-Ionen in die erste Schicht (13) zu dotieren und dadurch einen Störstoffbereich in der ersten Schicht (13) zu bilden.

7. Halbleiteranordnung, die durch das Verfahren nach ·Anspruch 1 erhalten werden kann, enthaltend:

ein Halbleitersubstrat (1) eines Leitfähigkeittyps;

einen Diffusionsbereich (2), der sich von einer Hauptoberfläche des Halbleitersubstrats (1) zu einem Inneren davon erstreckt, wobei der Diffusionsbereich einen Störstoff des Leitfähigkeittyps entgegengesetzt zu dem des Halbleitersubstrats aufweist und einen Kanalbereich bildet;

weitere Diffusionsbereiche (3, 4) mit dem Störstoff des entgegengesetzten Leitfähigkeittyps, die sich von der Hauptoberfläche erstrecken und Quellen-und Senkenbereiche bilden, die zu dem Gate-Bereich selbstausgerichtet sind;

eine Schicht mit einem Muster, die eine Übergangsmetallverbindung auf dem Halbleitersubstrat enthält und Quellen- (5), Gate- (9) und Senken- (6) Kontakte bildet;

wobei die Übergangsmetallverbindung eine nicht stöchiometrische Übergangsmetallverbindung ist, die wegen ihres Inhalts an Störstoff des entgegengesetzten Leitfähigkeitstyps stöchiometrisch gemacht ist;

wobie ein ohm'scher Kontakt zwischen den Quellen- (5) und Senken- (6) Kontakten und dem Substrat (1) gebildet ist;

wobei eine Schottky-Verbindung zwischen dem Gate-Kontakt (9) und dem Substrat gebildet ist.

8. Anordnung nach Anspruch 7, dadurch gekennzeichnet, daß das Übergangsmetall zum Bilden der Schicht (5, 6) einer nicht-stöchiometrischen Übergangsmetallverbindung wenigstens ein Element ausgewählt aus der Gruppe bestehend aus Ti, Hf, Zr, Ta, Nb und Sc enthält.

9. Anordnung nach Anspruch 7 oder 8, dadurch gekennzeichnet, daß die Schicht (5, 6) einer nicht stöchiometrischen Übergangsmetallverbindung ein Element ausgewählt aus der Gruppe bestehend aus Stickstoff und Kohlenstoff enthält.

10. Anordnung nach Anspruch 9, dadurch gekennzeichnet, daß der Gehalt an Stickstoff oder Kohlenstoff, der in der Schicht (5, 6) einer nicht-stöchiometrischen Übergangsmetallverbindung enthalten ist, innerhalb eines Bereichs zwischen 10 atomischen % und 80 atomischen % liegt.

11. Anordnung nach Anspruch 7 oder 9, dadurch gekennzeichnet, daß der Störstoff des Diffusionsbereichs ein Element ausgewählt aus der Gruppe bestehend aus P, B, Ge, Si, As, A, Te und Sn ist; der Störstoff der Schicht (5, 6) einer nicht-stöchiometrischen Übergangsmetallverbindung und des ohm'schen Kontakt-Störstoffbereichs ein Element ausgewählt aus der Gruppe bestehend aus As, Ga, Zn, A, S, Si, Ge, In, P, Sb, Te und Sn ist; und die Störstoffe des Diffusionsbereichs, der Schicht (5, 6) einer nicht stöchiometrischen Übergangsmetallverbindung und des ohm'schen Kontakt-Störstoffbereichs eine Konzentration von $10^{17}$ bis $10^{21}$ $cm^{-3}$ aufweisen.

**Revendications**

1. Procédé de formation d'un dispositif semi-conducteur, comprenant les étapes suivantes:

—dépôt d'une première couche (13) d'un composé de métal de transition interstitiel sur une surface principale d'un substrat semi-conducteur d'un premier type de conductivité,

—formation d'un masque (14) sur ladite couche (13) de composé de métal de transistion interstitiel,

—utilisation du masque (14) pour doper sélectivement ledit substrat semi-conducteur par une impuretée d'un second type de conductivité à travers ladite couche (13) de composé de métal interstitiel pour former une région de canal (2), dépôt sélectif d'une seconde couche (9a) d'une composé de métal de transition interstitiel sur ladite première couche (13) d'un composé de métal de transition interstitiel, ladite seconde couche de composée de métal de transition interstitiel formant une électrode de grille (9a), dopage par une autre impureté du second type de conductivité pour former des régions de source et de drain (3, 4) dans ledit substrat semi-conducteur (1) en utilisant ladite électrode de grille (9a) comme masque, configuration de ladite premièr couche (13) de composé de métal de transition interstitiel pour former des électrodes de source et de drain et recuisson de la structure ainsi formée, les impuretés et la température de recuit étant telles qu'un contact ohmique entre les électrodes de source et de drain et ledit substrat semi-conducteur est obtenu, et qu'une jonction de Schottky est obtenue entre ladite électrode de grill (9a) et ledit substrat semi-conducteur.

2. Procédé selon la revendication 1, caractérisé en ce qu'un composé de métal de transition interstitiel utilisé pour former ladite couche (13) de composé de métal de transition interstitiel est au moins un élément choisi dans le groupe formé par Ti, Hf, Zr, Ta, Nb et Sc.

3. Proceédé selon la revendication 1 ou 2, caractérisé en ce que ladite couche (13) de composé de métal de transition interstitiel contient un élément choisi dans le groupe formé par l'azote et le carbone.

4. Procédé selon la revendication 3, caractérisé en ce que la teneur en azote ou en carbone de ladite couche (13) de composé de métal de transition interstitiel est comprise entre 10% atomique et 80% atomique.

5. Procédé selon la revendication 1 ou 2, caractérisé en ce que l'impureté, pour former le contact atomique, que constitue l'agent de dopage dudit substrate semi-conducteur (1) et de ladite couche (13) de composé de métal de transition interstitiel est un élement choisi dans le groupe formé par As, Ge, P et Al et présente une concentration de $10^{17}$ à $10^{21}$ cm$^{-3}$.

6. Procédé de formation d'un substrat semi-conducteur selon la revendiction 1, caractérisé en ce que ladite étape de dépôt de ladite première couche (13) de composé de métal de transition interstitiel est interrompue de façon à doper ladite première couche (13) par des ions As et à former ainsi une région d'impureté dans ladite première couche (13).

7. Dispositif semi-conducteur que peut être obtenu par le procédé selon la revendication 1, comprenant:
—un substrat semi-conducteur (1) d'un type de conductivité,
—une région de diffusion (2) qui s'étend depuis une surface principale dudit substrat semi-conducteur (1) jusqu'à l'intérieur de celui-ci, ladite région de diffusion ayant une impureté d'un type de conductivé opposée à celui du substrat semi-conducteur et formant une région de canal,
—d'autres régions de diffusion (3, 4) comportant laite impuréte du type de conductivité opposé, que s'étendent depuis ladite surface principale et qui forment des régions de source et de drain en auto-alignement avec une région de grille,
—une couche configurée comprenant un composé de métal de transition sur ledit substrat semi-conducteur, et formant des contacts de source (5), de grille (9) et de drain (6),
—ledit composé de métal de transition étant un composé de métal de transition interstitiel rendu stoechiométrique du fait de sa teneur en ladite impureté du type de conductivité opposé,
—un contact ohmique étant formé entre les contacts de source (5) et de drain (6) et le substrat (1),
—une jonction de Schottky étant formée entre le contact de grille (9) et le substrat.

8. Dispositif selon la revendication 7, caractérisé en ce que le métal de transition destiné à former ladite couche (5, 6) de composé de métal de transition interstitiel comprend au moins un élément choisi dans le groupe formé par Ti, Hf, Zr, Ta, Nb et Sc.

9. Dispositif selon la revendiction 7 ou 8, caractérisé en ce que ladite couche (5, 6) de composé de métal de transition interstitiel contient un élément choisi dans le groupe formé par l'azote et le carbone.

10. Dispostif selon la revendication 9, caractérisé en ce que la teneur en azote ou en carbone de ladite couche (5, 6) de composé de métal de transition interstitiel est comprisé entre 10% atomique et 80% atomique.

11. Dispositif selon la revendication 7 ou 9, caractérisé en ce que l'impureté de ladite région de diffusion est un éément choisi dans le groupe formé par, P, B, Ge, Si, As, Al, Te et Sn, l'impureté de ladite couche (5, 6) de composé de métal de transition interstitiel et de ladite region d'impureté de contact ohmique est un élément choisi dans le groupe formé par As, Ga, Zn, Al, S, Si, Ge, In, P, Sb, Te et Sn, et les impuretés de ladite région de diffusion, de ladite couche (5, 6) de composé de métal de transition interstitiel et de ladite région d'impureté de contact ohmique ont une concentration de $10^{17}$ à $10^{21}$ cm$^{-3}$.

F I G. 1

F I G. 2

F I G. 3

F I G. 4

F I G. 5

F I G. 6

F I G. 7